(19) **Europäisches Patentamt European Patent Office Office européen des brevets**

(11) **EP 4 750 282 A1**

(12) **EUROPEAN PATENT APPLICATION**

(43) Date of publication:
27.05.2026 Bulletin 2026/22

(21) Application number: 25191775.3

(22) Date of filing: 25.07.2025

(51) International Patent Classification (IPC):
*H10K 30/88* (2023.01)

(52) Cooperative Patent Classification (CPC):
**H10K 30/88; H10F 19/804; H10F 19/807;**
H10K 30/40; H10K 85/50

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: 25.11.2024 CN 202422868751 U

(71) Applicant: **Suzhou Maxwell Technologies Co., Ltd.**
**Suzhou, Jiangsu 215200 (CN)**

(72) Inventors:
• **HU, Fengyang**
**Suzhou, Jiangsu 215200 (CN)**
• **ZHENG, Jing**
**Suzhou, Jiangsu 215200 (CN)**
• **YAN, Jianming**
**Suzhou, Jiangsu 215200 (CN)**
• **LI, Wei**
**Suzhou, Jiangsu 215200 (CN)**

(74) Representative: **Müller-Boré & Partner**
**Patentanwälte PartG mbB**
**Friedenheimer Brücke 21**
**80639 München (DE)**

(54) **LAMINATED PEROVSKITE SOLAR CELL**

(57) A laminated perovskite solar cell is provided, which relates to the field of battery technology. The laminated perovskite solar cell includes two protective components (100), a solar cell string (200), liquid silicone (300), and a waterproof component (400). The two protective components (100) are arranged to be spaced apart, and the solar cell string (200) is mounted between the two protective components (100). The liquid silicone (300) is coated on the surfaces of the protective components (100) facing the solar cell string (200), and the liquid silicone (300) bonds the protective components (100) to the solar cell string (200) after the liquid silicone (300) is cured. The waterproof component (400) is sandwiched between the two protective components (100) and arranged around the solar cell string (200) or wrapped on the outer sides of the protective components (100).

FIG. 1

Processed by Luminess, 75001 PARIS (FR)

**FIG. 5**

## Description

TECHNICAL FIELD

This application relates to the field of cell technology, and in particular to a laminated perovskite solar cell.

BACKGROUND

At present, laminated perovskite solar cells face a key technical problem that needs to be solved in the process of module encapsulation, that is, the delamination of the electron transport layer after encapsulation. Specifically, the interface bonding strength between the electron transport layer on the upper layer and the core perovskite layer of the cell is insufficient, which makes it prone for the adhesive film used in the encapsulation process to produce a pulling effect on the electron transport layer under the long-term stress, resulting in separation of the electron transport layer and the core perovskite layer. This delamination problem not only directly weakens the solar cell's power conversion efficiency and reduces the power generation capacity of the overall module, but also may cause hot spot phenomenon of the module due to local current concentration, further aggravating performance degradation, and seriously threatening the long-term stability and service life of the laminated perovskite solar cell.

Therefore, developing encapsulation materials and technologies with stronger adaptability and less stress influence has become a technical problem in improving the performance of laminated perovskite solar cells.

SUMMARY

An aspect of the present application is to provide a laminated perovskite solar battery, which effectively solves the delamination phenomenon caused by the interface bonding strength between the upper electron transport layer and the core perovskite layer of the perovskite tandem cell less than the stress applied by the adhesive film, and in addition, enables the lamination temperature to be lowered during the lamination process of the solar battery, to reduce the high temperature damage to the perovskite tandem cells.

To achieve this aspect, the following technical solution is adopted in the present application.

Embodiments of the present application provide a laminated perovskite solar cell. The laminated perovskite solar cell includes: two protective components, a solar cell string, liquid silicone, and a waterproof component. The two protective components are arranged to be spaced apart; the solar cell string is mounted between the two protective components; the liquid silicone is coated on surfaces of the protective components facing the solar cell string, and the liquid silicone bonds the protective components to the solar cell string after the liquid silicone is cured; and the waterproof component is sandwiched between the two protective components and arranged around the solar cell string, or the waterproof component is wrapped around outer sides of the two protective components.

In some embodiments, a surface of each protective component may be divided into at least one square region, and the amount of the liquid silicone corresponding to each of the at least one square region satisfies a relationship: $y=0.025X^2+0.163X$. Where X is the side length of one square region and has a unit of centimeters, and the unit of the amount y of the liquid silicone is grams.

In some embodiments, the thickness of the liquid silicone ranges from 0.3 mm to 0.5 mm.

In some embodiments, the thickness of each protective component ranges from 1 mm to 3 mm.

In some embodiments, the thickness of the waterproof component sandwiched between the two protective components ranges from 1 mm to 2 mm, or, the thickness of the waterproof component wrapped around the outer sides of the protective components ranges from 0.2 mm to 0.6 mm.

In some embodiments, the spacing between an outer peripheral wall and an inner peripheral wall of the waterproof component ranges from 5 mm to 11 mm.

In some embodiments, each of the protective components is a tempered glass plate.

In some embodiments, the waterproof component includes a butyl adhesive layer or a glass powder slurry sprayed on the surface of at least one of the protective components facing the solar cell string, or, the waterproof component includes an edge-sealing water-blocking tape wrapped around the outer sides of the protective components.

In some embodiments, multiple solar cell strings are provided, and the laminated perovskite solar cell further includes a bus bar and a junction box. The bus bar is configured to electrically connect multiple solar cell strings, and the junction box is connected to the bus bar and configured to be connected to an external device.

In some embodiments, each solar cell string includes multiple solar cells connected to each other, multiple soldering strips, and a wire film. The wire film is covered on multiple solar cells, and multiple soldering strips are sandwiched between the wire film and the multiple solar cells to conduct the multiple solar cells.

The following beneficial effects may be achieved based on the laminated perovskite solar battery of the present application. In practical working process, the liquid silicone is evenly scraped and coated on the surfaces of the two protective components, and then the solar cell strings are placed and soldered. After the protective components are scraped and coated with the liquid silicone, the protective components are bonded, and then the completed module is sent to a laminator for second-stage lamination to complete the encapsulation of the solar cell strings. The use of the liquid silicone for encapsulation effectively solves the delamination phenomenon caused by the interface bonding strength between the upper electron transport layer and the core perovskite layer of the perovskite tandem cell less than the stress applied by the adhesive film, and in addition, the use of the liquid silicone for encapsulation enables the lamination temperature to be lowered during the lamination process of the solar battery, which can reduce the high temperature damage to the perovskite tandem cells.

The additional aspects and advantages of the present application will be partially given in the following description, and part will become obvious from the following description, or will be understood through the practice of the present application.

BRIEF DESCRIPTION OF DRAWINGS

FIG. 1 is a schematic cross-sectional view showing the structure of the laminated perovskite solar cell according to a first embodiment of the present application;

FIG. 2 is a schematic structural diagram of the laminated perovskite solar cell according to a first embodiment of the present application;

FIG. 3 is a top view of a solar cell string according to the first embodiment of the present application;

FIG. 4 is a plan view of a solar cell string according to the first embodiment of the present application; and

FIG. 5 is a schematic cross-sectional view showing the structure of a solar cell string according to a second embodiment of the present application.

Reference numerals list:

100 protective component
200 solar cell string
210 solar cell
220 soldering strip
230 wire film
300 liquid silicone
400 waterproof component
500 bus bar
600 junction box

DETAILED DESCRIPTION

The present application is further described in detail hereinafter in conjunction with the drawings and embodiments. It can be understood that the embodiments described here are only intended to explain the present application, rather than limiting the present application. It should also be noted that, for the convenience of description, only part of the structures related to the present application, rather than all the structures, are shown in the drawings.

In the description of the present application, it is to be noted that, unless otherwise clearly specified and limited, the terms "connected to each other", "connected" or "fixed" are to be construed in a broad sense, for example, as permanently connected or detachably connected or integrally formed mechanically connected or electrically connected directly connected to each other or indirectly connected to each other via an intermediary or internally connection of two components or interaction relationship between two components. For the person of ordinary skill in the art, the meanings of the above terms in the present application may be construed according to specific circumstances.

In the description of this article, it should be understood that the orientation or position relationships indicated by the terms such as "upper", "lower", "right", etc., are based on the orientation or position relationship shown in the drawings, which is only for the convenience of description and simplification of operation, and does not indicate or imply that the device or element referred to must have a specific orientation, be constructed and operated in a specific orientation, and therefore cannot be understood as a limitation of the present application. Furthermore, the terms "first" and "second" are simply used to distinguish in the description and have no special meaning.

Embodiment One

Embodiments of the present application provide a laminated perovskite solar cell, which effectively solves the delamination phenomenon caused by the interface bonding strength between the upper electron transport layer and the core perovskite layer of the perovskite tandem cell less than the stress applied by the adhesive film, and in addition, enables the lamination temperature to be lowered during the lamination process of the solar cell to reduce the high temperature damage to the perovskite tandem cells.

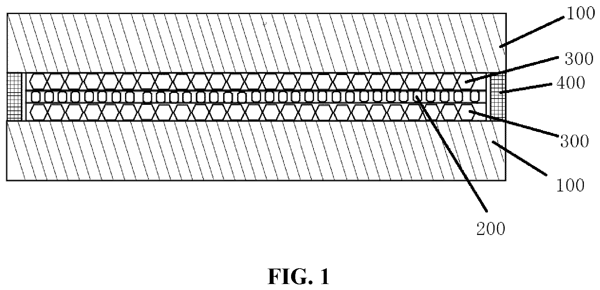

As shown in FIG. 1, the laminated perovskite solar cell includes two protective components 100, a solar cell string 200, liquid silicone 300, and a waterproof component 400. The two protective components 100 are arranged to be spaced apart from each other, and the solar cell string 200 is installed between the two protective components 100. The liquid silicone 300 is coated on the surfaces of the protective components 100 facing the solar cell string 200, and bonds the protective components 100 to the solar cell string 200 after the liquid silicone 300 is cured. The waterproof component 400 is sandwiched between the two protective components 100 and surrounds the solar cell string 200. It can be understood that in the practical working process, the liquid silicone 300 is evenly scraped and coated on the surfaces of the two protective components 100, and then the solar cell strings 200 are arranged and soldered. After the protective components 100 are scraped and coated with the liquid silicone 300, the protective components 100 are bonded, and then the completed module is sent to a laminator for two-stage lamination to complete the encapsulation of the solar cell strings 200. The use of the liquid silicone 300 for encapsulation effectively solves the delamination phenomenon caused by the interface bonding strength between the upper electron transport layer and the core perovskite layer of the perovskite tandem cell less than the stress applied by the adhesive film, and in addition, the use of the liquid silicone for encapsulation enables the lamination temperature to be lowered during the lamination process of the solar cell, which can reduce the high temperature damage to the perovskite tandem cells.

The following beneficial effects may be achieved based on the laminated perovskite solar cell of the present application. In the practical working process, the liquid silicone is evenly scraped and coated on the surfaces of the two protective components, and then the solar cell strings are placed and soldered. After the protective components are scraped and coated with the liquid silicone, the protective components are bonded, and then the completed module is sent to a laminator for two-stage lamination to complete the encapsulation of the solar cell strings. The use of the liquid silicone for encapsulation effectively solves the delamination phenomenon caused by the interface bonding strength between the upper electron transport layer and the core perovskite layer of the perovskite tandem cell less than the stress applied by the adhesive film, and in addition, the use of the liquid silicone for encapsulation enables the lamination temperature to be lowered during the lamination process of the solar cell, which can reduce the high temperature damage to the perovskite tandem cells.

In some embodiments, the surface of the protective component 100 may be divided into at least one square region, the amount of the liquid silicone 300 corresponding to each of the at least one square region satisfies the relationship: $y=0.025X^2+0.163X$, X is a side length of the square region, and has a unit of centimeters, and a unit of the amount y of the liquid silicone 300 is grams. It is understandable that in the practical working process, too little amount of liquid silicone 300 used will cause the bonding between the solar cell string 200 and the protective components 100 to be unstable, and bubbles are likely to exist between the solar cell string 200 and the protective components 100. If too much liquid silicone 300 is used, it will lead to waste of raw materials and be prone to causing the liquid silicone 300 to overflow during lamination. In this embodiment, by dividing the surface of the protective component 100 into at least one square region, and determining the amount of liquid silicone 300 according to the size of the square region, it ensures that the amount of liquid silicone 300 is moderate, which ensures that the protective components 100 are stably bonded to the solar cell string 200 and prevents bubbles from being produced between the solar cell string 200 and the protective components 100, and may avoid overflowing of the liquid silicone 300 from an adhesion location of a butyl adhesive on an edge portion of the protective component 100 as glass by penetrating therethrough in the process of lamination. Specifically, for a common perovskite tandem solar cell of 210-size, that is, a perovskite tandem solar cell with the protective component 100 having a length and width of 210 mm, the amount of liquid silicone 300 that needs to be applied to a single protective component 100 in the process of encapsulation is 1246.86 grams. The above equation may be applied to calculate the gram weight of liquid silicone 300 for modules of other sizes.

In some embodiments, the thickness of liquid silicone 300 ranges from 0.3 mm to 0.5 mm. Specifically, the thickness of liquid silicone 300 may be 0.3 mm, 0.31 mm, 0.32 mm, 0.33 mm, 0.34 mm, 0.35 mm, 0.36 mm, 0.37 mm, 0.38 mm, 0.39 mm, 0.4 mm, 0.41 mm, 0.42 mm, 0.43 mm, 0.44 mm, 0.45 mm, 0.46 mm, 0.47 mm, 0.48 mm, 0.49 mm, or 0.5 mm. Of course, the thickness of liquid silicone 300 may also be other values selected from the range of 0.3 mm to 0.5 mm according to practical requirements, and is not limited to the above examples. It is understandable that in the practical working process, a too small thickness of the liquid silicone 300 may cause an unstable bonding between the solar cell string 200 and the protective components 100 and may be prone to cause bubbles to exist between the two, while a too large thickness of the liquid silicone 300 may cause waste of raw materials and may be prone to cause the liquid silicone 300 to overflow during lamination. In this embodiment, the thickness of the liquid silicone 300 is controlled within the range from 0.3 mm to 0.5 mm, which may not only ensure a stable bonding between the solar cell string 200 and the protective components 100 and avoid bubbles from being formed between the two, but also avoid the liquid silicone 300 from overflowing during lamination, thereby avoiding material waste.

In some embodiments, the thermal expansion coefficient of liquid silicone is less than 0.0004L/Lo°C. The encapsulation with liquid silicone can reduce post-lamination stress, lower lamination temperature, and reduce damage to the battery cells.

In some embodiments, the thickness of the protective component 100 ranges from 1 mm to 3 mm. Specifically, the thickness of each of the protective components 100 may be 1 mm, 1.1 mm, 1.2 mm, 1.3 mm, 1.4 mm, 1.5 mm, 1.6 mm, 1.7 mm, 1.8 mm, 1.9 mm, 2 mm, 2.1 mm, 2.2 mm, 2.3 mm, 2.4 mm, 2.5 mm, 2.6 mm, 2.7 mm, 2.8 mm, 2.9 mm, or 3 mm. Of course, the thickness of each of the protective components 100 may also be other values selected from the range from 1 mm to 3 mm according to practical requirements, and is not limited to the above examples. It is understandable that a protective component 100 of a too small thickness may have an insufficient protection capability for the solar cell string 200, and a protective component 100 of a too large thickness may result in a large weight of the entire laminated perovskite solar cell, which will reduce the user experience. In this embodiment, the thickness of each of the protective components 100 is controlled within the range from 1 mm to 3 mm, which may not only ensure the protection capability for the solar cell string 200, but also control the weight of the laminated perovskite solar cell, thereby improving the user's practical experience.

In some embodiments, the thickness of the waterproof component 400 ranges from 1 mm to 2 mm. Specifically, the thickness of each of the protective components 100 may be 1 mm, 1.1 mm, 1.2 mm, 1.3 mm, 1.4 mm, 1.5 mm, 1.6 mm, 1.7 mm, 1.8 mm, 1.9 mm, or 2 mm. Of course, the thickness of the waterproof component 400 may also be other values selected from the range from 1 mm to 2 mm according to practical requirements, and is not limited to the above examples. Understandably, the waterproof component 400 is arranged around the solar cell string 200 to prevent external water vapor from entering, and if the thickness of the waterproof component 400 is too large, it will adversely affect the bonding effect between the solar cell string 200 and the liquid silicone 300, and increase the risk of delamination. If the thickness of the waterproof component 400 is too small, it will result in reduced waterproof and dustproof capabilities. In this embodiment, the thickness of the waterproof component 400 is controlled within the range from 1 mm to 2 mm, which will not adversely affect the bonding effect between the solar cell string 200 and the liquid silicone 300, and may ensure the waterproof and dustproof capabilities, and has a good protective effect on the solar cell string 200.

In some embodiments, the spacing between an outer peripheral wall and an inner peripheral wall of the waterproof component 400 ranges from 5 mm to 11 mm. For example, the spacing may be 5.1 mm, 5.2 mm, 5.3 mm, 5.4 mm, 5.5 mm, 5.6 mm, 5.7 mm, 5.8 mm, 5.9 mm, 6 mm, 6.1 mm, 6.2 mm, 6.3 mm, 6.4 mm, 6.5 mm, 6.6 mm, 6.7 mm, 6.8 mm, 6.9 mm, 7 mm, 7.1 mm, 7.2 mm, 7.3 mm, 7.4 mm, 7.5 mm, 7.6 mm, 7.7 mm, 7.8 mm, 7.9 mm, 8.1 mm, 8.2 mm, 8.3 mm, 8.4 mm, 8.5 mm, 8.6 mm, 8.7 mm, 8.8 mm, 8.9 mm, 9 mm, 9.1 mm, 9.2 mm, 9.3 mm, 9.4 mm, 9.5 mm, 9.6 mm, 9.7 mm, 9.8 mm, 9.9 mm, 10.1 mm, 10.2 mm, 10.3 mm, 10.4 mm, 10.5 mm, 10.6 mm, 10.7 mm, 10.8 mm, 10.9 mm, or 11 mm. Of course, the width of the waterproof component 400 may also be other values selected from the range from 5 mm to 11 mm according to practical requirements, and is not limited to the above examples. It is understandable that if the width of the waterproof component 400 is too large, the width of the useless portion of the entire laminated perovskite solar cell will be too large, and if the width of the waterproof component 400 is too small, the waterproof and dustproof performance may be adversely affected. In this embodiment, the width of the waterproof component 400 is controlled to be within the range from 5 mm to 11 mm, which may not only control the width of useless portion of the laminated perovskite solar cell, increase the effective area, but also ensure the waterproof and dustproof capabilities, and have a good protective effect on the solar cell string 200.

In some embodiments, the protective component 100 is a tempered glass plate. Thus, the protective component 100 not only plays a good protective role, but also does not affect the normal absorption of light energy by the solar cell string 200. Of course, in other embodiments of the present application, the protective component 100 may also be selected from other materials according to practical requirements.

In some embodiments, the waterproof component 400 includes a butyl adhesive layer or a glass powder slurry applied to the surface of at least one protective component 100 facing the solar cell string 200. The waterproof component 400 is a butyl adhesive layer formed by spraying. The butyl adhesive layer is convenient for assembly in one aspect, and has good waterproof and dustproof performances in another aspect. Of course, in this embodiment, the material of the waterproof component 400 may also be selected according to practical requirements.

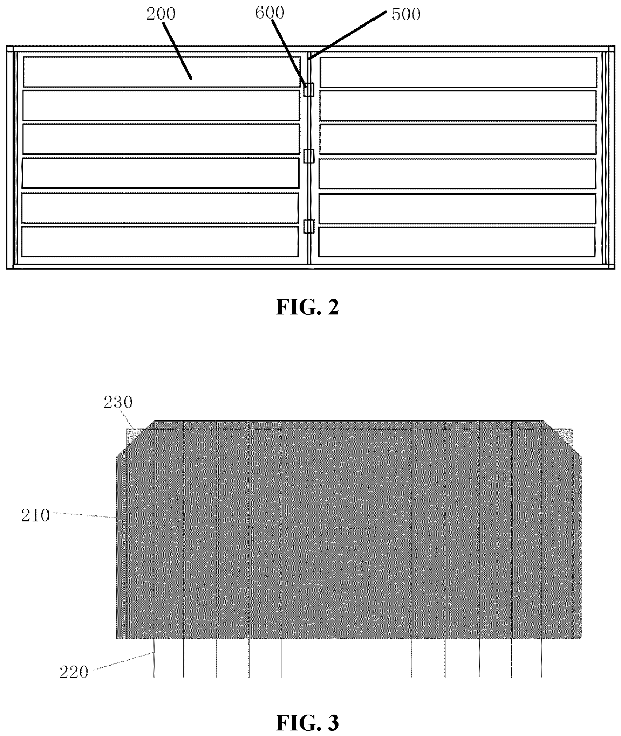

In some embodiments, as shown in FIG. 2, multiple solar cell strings 200 are provided, and the laminated perovskite solar cell further includes a bus bar 500 and a junction box 600. The bus bar 500 is used to realize the electrical connection of multiple solar cell strings 200. The junction box 600 is connected to the bus bar 500 and is used to connect to external devices. It can be understood that a laminated perovskite solar cell formed of multiple solar cell strings 200 may improve the capacity of the laminated perovskite solar cell and improve user satisfaction. The bus bar 500 may facilitate the electrical connection between multiple solar cell strings 200, and the additionally provided junction box 600 may facilitate the lead-out of the laminated perovskite solar cell.

In some embodiments, each solar cell string 200 is rectangular in shape, and multiple solar cell strings 200 are arranged in multiple rows and columns in their width direction and length direction. It can be understood that multiple solar cell strings 200 are arranged in multiple rows and columns in their width direction and length direction, which may facilitate the assembly of the laminated perovskite solar cell.

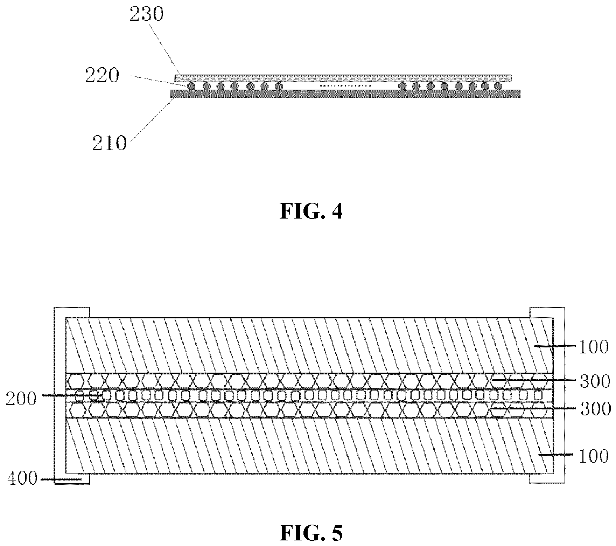

Optionally, referring to FIG. 3 and FIG. 4, each solar cell string 200 includes multiple solar cells 210 connected to each other, multiple soldering strips 220, and a wire film 230. The wire film 230 covers the multiple solar cells 210, and the multiple soldering strips 220 are sandwiched between the wire film 230 and the multiple solar cells 210 to conduct the multiple solar cells 210. It is understandable that after the multiple solar cells 210 and the multiple soldering strips 220 are arranged in sequence, the wire film 230 is formed on the surface by coating to complete assembly of the multiple solar cells 210 in strings, which may not only facilitate the stringing of the multiple solar cells 210, but also play a certain protective role for the multiple solar cells 210.

One of the manufacturing methods of the laminated perovskite solar cell of this embodiment is as follows.

First: a butyl adhesive is sprayed around the tempered glass plates to enhance the waterproof performance.

Second: liquid silicone 300 is evenly scraped and coated on the surfaces of the two tempered glass plates, and then the solar cell strings 200 are arranged and soldered on the tempered glass plates. It should be noted that the solar cells applicable to the solar cell strings 200 in this embodiment are perovskite tandem cells.

Third: after the liquid silicone 300 is evenly scraped and coated on the tempered glass plates, the tempered glass plates are bonded.

Fourth: the completed module is sent to the laminator for two-stage lamination. It should be noted here that since the perovskite cell is not resistant to high temperature, the laminator is set to be at a temperature of 70 degrees Celsius, with a vacuuming time of 480 seconds and a lamination time of 480 seconds in a first-stage lamination of the two-stage lamination, and at a temperature of 120 degrees Celsius, with a vacuuming time of 360 seconds and a lamination time of 600 seconds in a second-stage lamination of the two-stage lamination. The first-stage lamination is vacuumed at a relatively low temperature to ensure that the bubbles in the middle of the module are discharged before the liquid silicone 300 begins to solidify, and the second-stage lamination makes the liquid silicone 300 completely solidify and bond. The specific vacuuming and lamination times in the first-stage and second-stage lamination processes are determined by experiments on laminators from different manufacturers.

Fifth: After the module lamination is completed, the junction box 600 is installed to complete the assembly.

Embodiment Two

The structure of the laminated perovskite solar cell of this embodiment is roughly the same as that of the first embodiment, except that the structure of the waterproof component 400 is different. As shown in FIG. 5, the waterproof component 400 of this embodiment is wrapped around the outer sides of the two protective components 100, and the waterproof component 400 includes an edge-sealing water-blocking tape wrapped around the outer sides of the protective components 100, and the thickness ranges from 0.2 mm to 0.6 mm. Optionally, the edge-sealing water-blocking tape may be an aluminum foil tape or a water-blocking tape made of other materials.

In the description of this specification, the description of the reference terms "some embodiments", "other embodiments", etc., means that the specific features, structures, materials, or characteristics described in conjunction with the embodiment or example are included in at least one embodiment or example of the present application. In this specification, the schematic representation of the above terms does not necessarily refer to the same embodiment or example. Moreover, the specific features, structures, materials, or characteristics described can be combined in suitable manners in any one or more embodiments or examples.

The above embodiments of the present application are merely examples for clearly illustrating the present application, and are not intended to limit the implementation methods of the present application. For ordinary technicians in the relevant field, various obvious changes, readjustments, and substitutions can be made without departing from the scope of protection of the present application. It is not necessary and impossible to list all the implementation methods here. Any modification, equivalent substitution and improvement made within the spirit and principle of the present application should be included in the scope of protection of the claims of the present application.

**Claims**

1. A laminated perovskite solar cell, comprising:

   two protective components (100), arranged to be spaced apart;
   a solar cell string (200), mounted between the two protective components (100);
   liquid silicone (300), coated on surfaces of the protective components (100) facing the solar cell string (200), and capable of bonding the protective components (100) to the solar cell string (200) after the liquid silicone (300) is cured; and
   a waterproof component (400), sandwiched between the two protective components (100) and arranged around the solar cell string (200); or, wrapped around outer sides of the two protective components (100).

2. The laminated perovskite solar cell according to claim 1, wherein a surface of each of the protective components (100) comprises at least one square region, and an amount of the liquid silicone (300) corresponding to each of the at least one square region satisfies a relationship:

$$y=0.025X^2+0.163X,$$

wherein X is a side length of one square region and has a unit of centimeters, and a unit of the amount y of the liquid silicone (300) is grams.

3. The laminated perovskite solar cell according to any one of the preceding claims, wherein a thickness of the liquid silicone (300) ranges from 0.3 mm to 0.5 mm.

4. The laminated perovskite solar cell according to any one of the preceding claims, wherein a thickness of each of the protective components (100) ranges from 1 mm to 3 mm.

5. The laminated perovskite solar cell according to any one of the preceding claims, wherein the waterproof component (400) sandwiched between the two protective components (100) has a thickness ranging from 1 mm to 2 mm; or, the waterproof component (400) wrapped around the outer sides of the protective components (100) has a thickness ranging from 0.2 mm to 0.6 mm.

6. The laminated perovskite solar cell according to any one of the preceding claims, wherein a spacing between an outer peripheral wall and an inner peripheral wall of the waterproof component (400) ranges from 5 mm to 11 mm.

7. The laminated perovskite solar cell according to any one of the preceding claims, wherein each of the protective components (100) is a tempered glass plate.

8. The laminated perovskite solar cell according to any one of the preceding claims, wherein the waterproof component (400) comprises a butyl adhesive layer or a glass powder slurry sprayed on the surface of at least one of the protective components (100) facing the solar cell string (200); or, the waterproof component (400) comprises an edge-sealing water-blocking tape wrapped around the outer sides of the protective components (100).

9. The laminated perovskite solar cell according to any one of the preceding claims, wherein a plurality of solar cell strings (200) are provided, and the laminated perovskite solar cell further comprises:

   a bus bar (500), configured to electrically connect a plurality of solar cell strings (200); and
   a junction box (600), connected to the bus bar (500) and configured to be connected to an external device.

10. The laminated perovskite solar cell according to any one of the preceding claims, wherein the solar cell string (200) comprises a plurality of solar cells (210) connected to each other, a plurality of soldering strips (220), and a wire film (230);
    wherein the wire film (230) is covered on the plurality of solar cells (210), and the plurality of soldering strips (220) are sandwiched between the wire film (230) and the plurality of solar cells (210) to conduct the plurality of solar cells (210).

11. The laminated perovskite solar cell according to any one of the preceding claims, wherein a plurality of solar cell strings (200) are provided, each of the plurality of solar cell strings (200) is rectangular in shape, and the plurality of solar cell strings (200) are arranged in a plurality of rows and a plurality of columns in a width direction and a length direction of the plurality of solar cell strings (200).

12. A manufacturing method of the laminated perovskite solar cell according to any one of the preceding claims, comprising:

    spraying a butyl adhesive around two tempered glass plates to enhance a waterproof performance;
    wherein the two tempered glass plates are the two protective components (100);
    evenly scraping and coating the liquid silicone (300) on surfaces of the two tempered glass plates,
    and arranging and soldering a plurality of solar cell strings (200) on the tempered glass plates;
    bonding the tempered glass plates;
    sending the bonded tempered glass plates to a laminator for a two-stage lamination; and
    installing a junction box (600) on the bonded tempered glass plates to complete an assembly of the laminated perovskite solar cell.

13. The manufacturing method of the laminated perovskite solar cell according to claim 12, wherein

    a vacuuming time in a first-stage lamination of the two-stage lamination is 480 seconds, and a lamination time in the first-stage lamination is 480 seconds; and
    a vacuuming time in a second-stage lamination of the two-stage lamination is 360 seconds, and a lamination time in the second-stage lamination is 600 seconds.

14. The manufacturing method of the laminated perovskite solar cell according to claim 12 or 13, wherein a surface of each of the protective components (100) comprises at least one square region, and an amount of the liquid silicone (300) corresponding to each of the at least one square region satisfies a relationship:

$$y=0.025X^2+0.163X,$$

wherein X is a side length of one square region and has a unit of centimeters, and a unit of the amount y of the liquid silicone (300) is grams.

15. The manufacturing method of the laminated perovskite solar cell according to claim 12, 13 or 14, wherein at least one of the following configurations is satisfied:

a thickness of the liquid silicone (300) ranges from 0.3 mm to 0.5 mm; or
a thickness of each of the protective components (100) ranges from 1 mm to 3 mm.

**FIG. 1**

200   600   500

**FIG. 2**

230

210

220

**FIG. 3**

230

220

210

**FIG. 4**

100

300

200

300

400

100

**FIG. 5**

Europäisches
Patentamt

European
Patent Office

Office européen
des brevets

# EUROPEAN SEARCH REPORT

**Application Number**

EP 25 19 1775

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 221 429 477 U (UNIV XINYANG NORMAL) 26 July 2024 (2024-07-26) * paragraphs [0011], [0020] - [0054]; figures 1,2 * | 1-12,14, 15 | INV. H10K30/88 |
| X | G. BEAUCAME ET AL.: "LOW TEMPERATURE SOLAR CELL ENCAPSULATIONWITH NOVEL SILICONE ELASTOMER FOR BUILDING INTEGRATED PV", 8TH WORLD CONFERENCE ON PHOTOVOLTAIC ENERGY CONVERSION, WIP-RENEWABLE ENERGIES, SYLVENSTEINSTR. 2 81369 MUNICH, GERMANY, 30 September 2022 (2022-09-30), pages 893-897, XP040732074, ISBN: 978-3-936338-86-7 * page 894 - page 896; figures 1,2 * | 1-15 | |
| A | CN 116 056 474 A (WUXI JIDIAN LIGHT ENERGY TECH CO LTD) 2 May 2023 (2023-05-02) * page 2 - page 5; figure 1 * | 1-15 | |
| A | WO 2015/096493 A1 (SHENZHEN BYD AUTO R & D CO LTD [CN]; BYD CO LTD [CN]) 2 July 2015 (2015-07-02) * paragraphs [0005] - [0066]; figures 1-3 * | 1-15 | |

**TECHNICAL FIELDS SEARCHED (IPC)**

H10K
H10F

The present search report has been drawn up for all claims

| Place of search | Date of completion of the search | Examiner |
|---|---|---|
| The Hague | 17 December 2025 | Tena Zaera, Ramon |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
..................................................................................................
& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 25 19 1775

This annex lists the patent family members relating to the patent documents cited in the above-mentioned European search report.
The members are as contained in the European Patent Office EDP file on
The European Patent Office is in no way liable for these particulars which are merely given for the purpose of information.

17-12-2025

| Patent document cited in search report | | | Publication date | Patent family member(s) | | | Publication date |
|---|---|---|---|---|---|---|---|
| CN 221429477 | U | | 26-07-2024 | NONE | | | |
| CN 116056474 | A | | 02-05-2023 | NONE | | | |
| WO 2015096493 | A1 | | 02-07-2015 | CN | 203746873 | U | 30-07-2014 |
| | | | | EP | 3089220 | A1 | 02-11-2016 |
| | | | | JP | 6289643 | B2 | 07-03-2018 |
| | | | | JP | 2017501582 | A | 12-01-2017 |
| | | | | KR | 20160090356 | A | 29-07-2016 |
| | | | | US | 2016322525 | A1 | 03-11-2016 |
| | | | | WO | 2015096493 | A1 | 02-07-2015 |

EPO FORM P0459

For more details about this annex : see Official Journal of the European Patent Office, No. 12/82